# EUROPEAN PATENT APPLICATION

(11) **EP 0 600 637 A1**
(43) Date of publication of application: **08.06.1994**
(21) Application number: 93309198.5
(22) Date of filing: 18.11.1993
(51) Int. Cl.: G01S 7/34

(54) **System for distributed digital receiver gain control**

(30) Priority: 01.12.1992 US 983927
(71) Applicant: Hughes Aircraft Company, Los Angeles, California 90045-0066 (US)
(72) Inventor: Docter, Richard A., Chino, California 91710 (US); Siddoway, Ronald T., Fullerton, California 92633 (US)
(74) Representative: Colgan, Stephen James

(57) **Abstract**

The invention provides for a system of controlling the gain of a receiver in which the gain control of the receiver is distributed at two or more points in the receiver. This results in constant receiver gain without degradation of either the noise figure or the third order intermodulation of the receiver. The present invention includes a means for measuring the level of the receiver noise, a means for comparing the measured noise to a desired noise level, a means of determining the required degree of attenuation, and means to attenuate the receiver gain by feedback of a signal to multiple points within the receiver. The invention also provides for a system for controlling the gain of a radar or other type of receiver which is required to handle two or more simultaneous signals.

## Description

### BACKGROUND OF THE INVENTION

### FIELD OF THE INVENTION

This invention relates generally to information processing, and more particularly to the field of receiver signal gain control. A particular use of the invention is in radar receivers which must handle two or more simultaneous signals.

### PRIOR ART

As high dynamic range receivers have been developed for advanced radar systems, gain control of receiver signals has become increasingly difficult. Analog gain control methods have proven inadequate and thus digital control receiver gain control (RGC) has been developed in an attempt to control the gain of high dynamic range receivers. Digital control RGC operates by determining the noise level of the receiver, comparing it to a desired level and then adjusting the receiver gain accordingly. The receiver gain adjustment is performed by a single digital control step attenuation means located within the receiver.

Automatic Gain Control (AGC) is similar in method but not in concept. It uses the presence of a signal to control the feedback amount of gain control in a receiver, varying the receiver's gain in response to the amount of signal present. Digital Control RGC, in contrast, has no requirement that a signal be present.

Digital control RGC employs an accumulator means for sampling and averaging the digitized receiver output and generating an average noise level value. This value is compared to the desired value by a digital logic means, which determines whether to increment or decrement the step attenuation means within the receiver. This feedback system acts to maintain the receiver gain at a constant value.

The two parameters used as figures of merit for determining the quality of a receiver required to handle two simultaneous signals are the noise figure and the third order intercept point (intermodulation). It is highly desirable to keep these quality parameters constant as the attenuation is increased, in order to avoid masking data behind noise.

While digital control RGC has many advantages, one disadvantage is that as the receiver attenuation is increased, the two quality measurements also increase. Thus, high dynamic range receivers that use conventional digital control can only achieve acceptable noise figure and intermodulation values by increasing size and power. It would be highly desirable to develop a system for maintaining the gain of a high dynamic range receiver without degrading the noise figure or intermodulation values and without increasing the size and power of the receiver. The present invention was developed to address this need.

### SUMMARY OF THE INVENTION

The present invention provides for a system of controlling the gain of a receiver, and particularly a radar receiver, in which the gain control of the receiver is distributed at two or more points in the receiver. This system results in constant receiver gain without degradation of either the noise figure or the third order intermodulation of the receiver.

Briefly, and in general terms, the system for controlling receiver gain according to the present invention is advantageously used in a radar receiver and includes a means for measuring the level of the receiver noise; a means for comparing the measured noise to a desired noise level; a means of determining the required degree of attenuation; and means to attenuate the receiver gain by feedback of a signal to multiple points within the receiver. The invention also provides for a system for controlling the gain of a radar or other type of receiver which is required to handle two or more simultaneous signals. In this application, the invention has an accumulator means for measuring the average value of the receiver noise; a digital logic means for generating an incremental command signal when the measured noise level is below the desired level, and a decremental command signal when the measured noise level exceeds the desired level; a control algorithm means for converting the command signal to attenuation signals; and a plurality of digital control step attenuation means for feeding back adjustments to receive gain in response to the attenuation signals.

In one preferred embodiment of the invention the control algorithm means would increment each of the step attenuation means in a rotation sequence from the rear to the front of the receiver, with the sum total of desired attenuation distributed at a plurality of points in the receiver.

From the above, it may be seen that the present invention has important advantages related to the gain control of high performance receivers, and particularly radar receivers. Other aspects and advantages of the invention will become apparent from the following detailed description and the accompanying drawings, which illustrate by way of example the features of the invention.

### BRIEF DESCRIPTION OF THE DRAWINGS

Figure I is a schematic diagram of a system for gain control of a receiver according to the prior art.

Figure 2 is a schematic diagram of a system for distributed gain control of a radar receiver according to the present invention.

Figure 3 is a graph of the noise figure of merit versus attenuator step number, comparing the non-distributed to the distributed gain control.

Figure A is a graph of the intermodulation figure of merit versus attenuator step number, comparing the non-distributed to the distributed gain control.

### DETAILED DESCRIPTION OF THE INVENTION

As is shown in the drawings, which are included for the purpose of illustration, the invention is embodied in a system for controlling the gain of a radar or other type of receiver such that gain control is distributed to multiple points within the receiver. The quality of a receiver required to handle two or more simultaneous signals is determined by the receiver noise figure of merit and the third order intercept point (intermodulation figure of merit). Single point digital control receiver gain control (RGC) in common usage in the art, which feeds back gain control to a single point, results in linear increases of these two quality measurements as attenuation to the receiver is increased. To compensate for this condition, the size and power of the receiver must be increased to obtain desired performance results. In addition, the fluctuations of temperature, aging and manufacturing tolerances affect individual receiver components differently, and it is difficult to compensate for these effects with single point digital control RGC.

Receiver gain control (RGC) has been implemented in a variety of existing radar systems. During a period in which there is only receiver thermal noise present, an accumulator averages the value of the receiver thermal noise. After sufficient averaging, the value is compared to the desired level of noise. An increment up or down command is generated by a digital logic function based on whether the measured level is too low or high, respectively. The process is repeated until there is no further change from measurement to measurement. This final value is maintained until an update is deemed necessary. The up/down signal drives a digitally controlled step attenuator in the IF section of the receiver. While the attenuator is located in the IF section, the attenuator could be located anywhere in the receiver after the low noise amplifier at the input. The accumulator is used to determine the receiver noise level and averages the value of the receiver thermal noise. After sufficient averaging, the value is compared to the desired level of noise. An incremental up or down command is generated, based on whether the measured level is too low or high, respectively.

By distributing the gain correction to multiple points within the receiver, the present invention achieves constant gain without degradation to either the noise or the intermodulation figure of merit. Since the overall gain correction is spread within the receiver, the impact on the individual receiver components is minimized.

As a receiver is built and calibrated in various pieces and then exposed to an environment of changing temperature plus aging effects, there is a variability in each of the component pieces which comprise the receiver. The combination of calibration changes, temperature fluctuations, and aging causes each component to change gain. Since the gain change is a distributed phenomena, attempting to correct the cumulative effect in one place in the receiver compromises both NF and IP3. The key feature of the DDRGC is that it alleviates much of the compromise by correcting gain in multiple points, in effect distributing the gain correction.

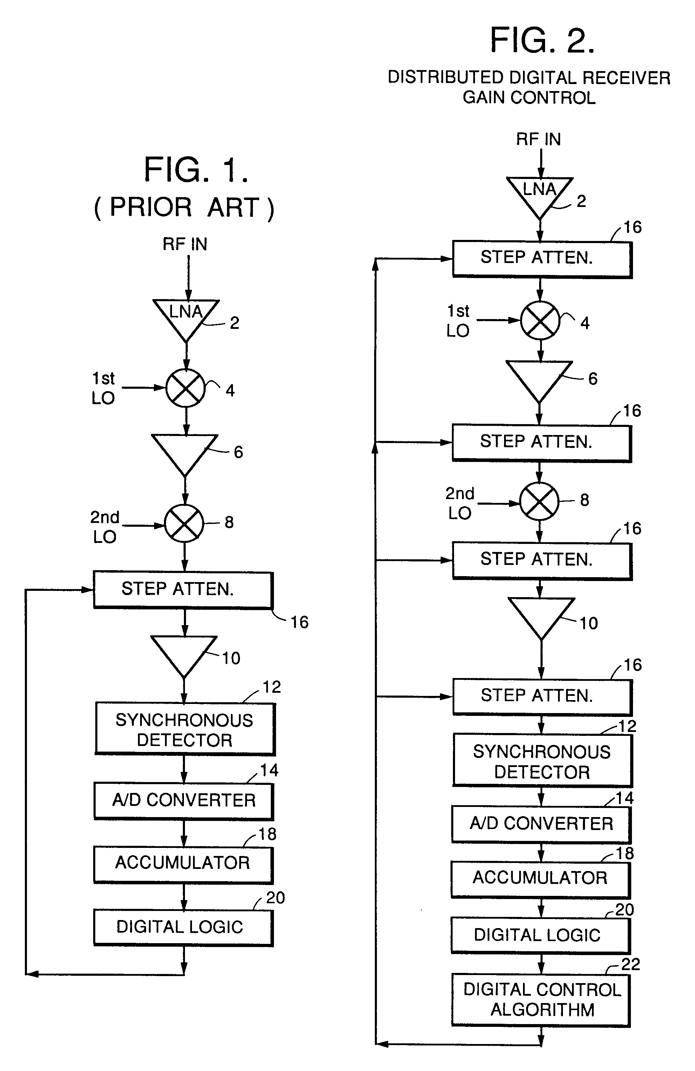

The typical radar receiver of the prior art in Figure 1 consists of a low noise amplifier 2 followed by a conversion mixer 4, a first intermediate frequency (IF) stage 6, another conversion mixer 8, a second IF stage 10, and finally a synchronous detection circuit 12, which results in quadrature video (or base band) components of the detected signal. A step attenuator 16 controls the gain of the receiver on the basis of inputs from the accumulator 18 and digital logic 20 which commands the step attenuator to maintain constant gain at the output. The video signals are digitized in the A/D converter 14 and processed digitally for subsequent target detection and Doppler filtering.

Referring to figure 2, which illustrates the present invention, located at multiple places in the receiver are digitally controlled step attenuators (16). These devices are available commercially in a variety of forms. They generally consist of PIN diodes used as switching devices used to select a variety of attenuators in some logical sequence. A typical step attenuator will have I dB steps over a range of 8 to 32 dB. For a receiver where the expected range of gain fluctuations was 8 to I2 dB, four step attenuators would be appropriate, each with a range of 4 dB for a total range of I6 dB.

In a preferred embodiment of the invention, the digital control step attenuation means will be located within the receiver as follows: the first step attenuation means 16 located after the receiver low noise amplifier 2 and before the first conversion mixer 4; the second step attenuation 16 means located after the first intermediate frequency stage 6 and before the second conversion mixer 8; the third step attenuation 16 means located after the second intermediate frequency stage 10 and before the synchronous detector 12 for the receiver. Other configurations for the placement of the step attenuation means 16 are possible within the spirit of the invention. For example, in a receiver with an expected gain fluctuation of I2dB, an embodiment of the invention would be to use 4 individual step attenuation means, each with a range of 4dB. This embodiment gives the receiver a total gain control range of I6dB.

Before commanding the individual step attenuation means, the total amount of receiver attenuation required must be determined. First, a sampling of the digitized receiver output is performed by an accumulator means 18. Then, the accumulator means 18 measures the average value of the sampled receiver noise. The measured value is then provided to the digital logic means 20. The digital logic 20 means compares the measured value to the desired noise level for the receiver. An incremental command signal is generated if the measured value is too low, and a decremental command signal is generated if the measured value is too high. Similar digital logic means are used in single point digital control RGC. The command signal is then provided to the control algorithm means.

The implementation of multiple points of gain control of the present invention requires a decision process to select the appropriate step attenuator to increment or decrement for each gain change. One method would be to increment each step attenuator in rotation from the rear to the front but other strategies may be used.

In a preferred embodiment of the present invention, gain control of the receiver is achieved by sampling the digitized receiver output with accumulator 18 to measure the average noise level using digital logic 20 to compare that noise level to a desired level; then, providing feedback control via a digital control algorithm means 22 to multiple points within the receiver. The feedback system maintains the measured noise level at the desired level.

The decision as to how much gain control is required and how it will be distribute among the step attenuation means is performed by the digital control algorithm means 22. The control algorithm 22 means sends increment or decrement commands to each of the step attenuation means in response to the command signals. This use of the control algorithm is an important feature of the invention and provides substantial benefits in the gain control of the receiver, since each step attenuator will be commanded for control attenuation in a way which reduces the overall distortion and noise.

In a preferred embodiment of the invention, the control algorithm means will increase the attenuation level to each of the step attenuation means in a rotational sequence. The control algorithm insures that each of the step attenuation means provides an equal amount of gain control with the greatest amount of attenuation provided by the rear most of the step attenuation means.

Table I illustrates the settings of the control attenuator for one control algorithm which has been found to provide good control of receiver gain with the invention.

**TABLE I**

| Receiver | Step Attenuator Setting (dB) | | | |
|---|---|---|---|---|
| Gain | Atten. I | Atten. 2 | Atten. 3 | Atten. 4 |
| 0 | 0 | 0 | 0 | 0 |
| 1 | 0 | 0 | 0 | 1 |
| 2 | 0 | 0 | 1 | 1 |
| 3 | 0 | 1 | 1 | 1 |
| 4 | 1 | 1 | 1 | 1 |
| 5 | 1 | 1 | 1 | 2 |
| 6 | 1 | 1 | 2 | 2 |
| 7 | 1 | 2 | 2 | 2 |
| 8 | 2 | 2 | 2 | 2 |
| 9 | 2 | 2 | 2 | 2 |
| 10 | 2 | 2 | 3 | 3 |
| 11 | 2 | 3 | 3 | 3 |
| 12 | 3 | 3 | 3 | 3 |
| 13 | 3 | 3 | 3 | 4 |
| 14 | 3 | 3 | 4 | 4 |
| 15 | 3 | 4 | 4 | 4 |

The above described process of measuring the receiver noise level and making incremental adjustments to the gain is continuous, so that the receiver will always be operating at a near optimum level, despite fluctuations in temperature, aging or manufacturing tolerance between receiver components.

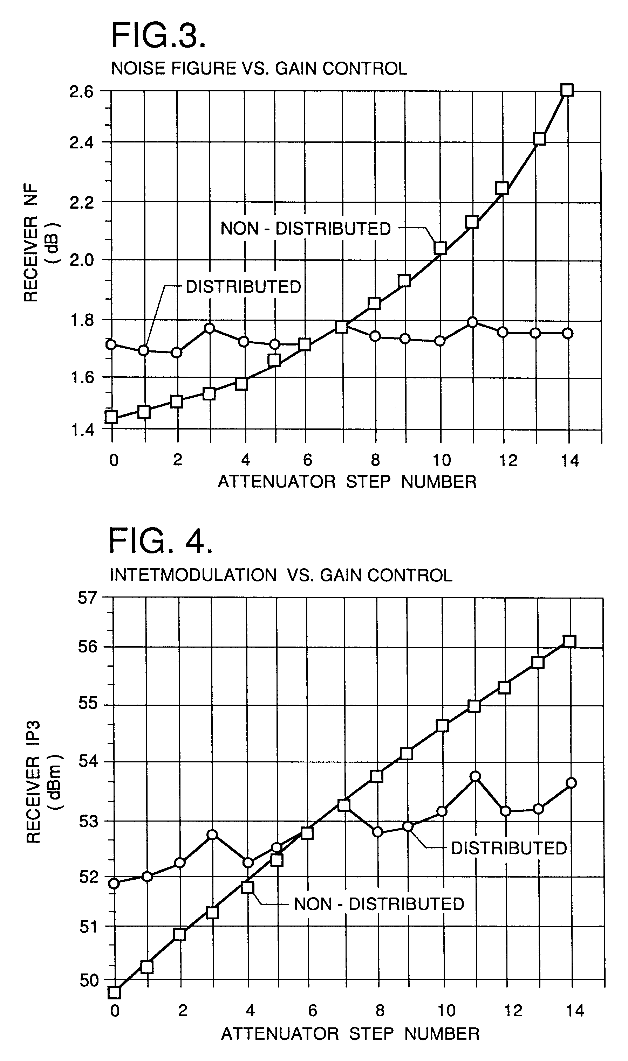

Computer analysis of receiver dynamic range has been performed to characterize the improvements made by use of the invention. Using the computer program, which has proven accurate in other applications, an analysis was performed on a contemporaneous radar receiver currently being optimized for dynamic range. An initial receiver configuration was chosen and components selected to provide good dynamic range. Single point RGC was then added just prior to the synchronous detector. Results of the computer analysis of the noise figure of merit, NF and the intermodulation figure of merit, IP3 for the single point attenuator means receiver are plotted in Figures 3 and 4. Note the sizable degradation of NF for large values of attenuation using a single attenuator means. The receiver configuration was then altered in the simulation to add multipoint step attenuators. Analysis was repeated in the same fashion and also plotted in Figures 3 and 4. As can be seen in a comparison of the two figures, there is a sizable improvement in the control of the figures of merit for the Distributed Digital RGC configuration of the present invention. It may be noted that in Figure 3 the noise figure of the non-distributed RGC receiver is superior to the distributed RGC receiver with attenuation step levels less than 6. Also, in Figure 4 the third order intercept point is higher for the non-distributed RGC receiver when the attenuation level is set to step 8 or higher, The goal of the invention is to keep the performance parameters (noise figure and third order intercept point) nearly constant for varying RGC settings, which are dictated by the environment and performance of each individual component within the receiver channel. The goal is not to peak the performance at one particular gain setting.

Those skilled in the art will appreciate from the foregoing description that the present invention for controlling receiver gain can achieve a significant improvement in gain control with less degradation of the noise figure of merit or intermodulation figure of merit compared to the single point RGC prior art. While a particular form of the invention has been described, it will be apparent that various modifications can be made without departing from the spirit and scope of the invention.

## Claims

1. A system and method for controlling the gain of a receiver by distributing gain control to multiple points.

2. The system of Claim 1, which comprises:
a plurality of step attenuation means 16 located at a plurality of points in the receiver for incrementally adjusting the gain of said receiver;
a means 18 for measuring the average value of noise output by said receiver;
a logic means 20 for comparing said measured noise value of said receiver noise to a desired noise level and generating a command signal;
a control means 22 for converting said command signal to attentuation signals for separately controlling each of said step attenuation means.

3. The system of Claim 1, wherein said step attenuation means 16 control the gain of said receiver in response to feedback control signals from said logic means 20.

4. The system of Claim 1, wherein said noise measurement means 18 measures the average value of the noise output by said receiver by sampling the digitized output of said receiver, and said measured noise value is provided to said logic means 20.

5. The system of Claim 1, wherein said logic means 20 generates an incremental command signal when the measured value is below a desired noise level, and a decremental command signal when the measured noise value exceeds a desired noise level, and said incremental or decremental command signal is provided to said control means 22.

6. The system of Claim 1, wherein said control means 22 determines the total amount of receiver attenuation required, and selects the appropriate attenuation command signals for each of said step attenuation means 16 in response to incremental command signals and decremental command signals, and attenuation is distributed among said step attenuation means 16, and the step attenuation means 16 closest to the input of said receiver will be set for the highest degree of attenuation.

7. The system of Claim 1, wherein said receiver is a radar receiver.

8. The system of Claim I, wherein said logic means 20 comprises digital logic means.

9. The method of Claim 1, which comprises:
measuring the output noise of the receiver;
comparing said measured noise output with a desired noise level;
generating a command signal based upon said comparison;
converting said command signal to a plurality of control signals suitable to drive attenuator means; and
controlling a plurality of attenuation means 16 in said receiver by said control signals to reduce the difference between said measured noise level and a desired noise level.
